# EUROPÄISCHE PATENTSCHRIFT

(11) **EP 4 075 456 B1**
(45) Veröffentlichungstag und Bekanntmachung des Hinweises auf die Patenterteilung: **02.10.2024**
(21) Anmeldenummer: 22163175.7
(22) Anmeldetag: 21.03.2022
(51) Int. Cl.: H01C 1/144, B23K 26/00, H01L 23/00, H05K 3/30

(54) **VERFAHREN ZUM HERSTELLEN EINES LÖTBAREN BAUELEMENT UND FELDGERÄT MIT BAUELEMENT**
METHOD FOR MANUFACTURING A SOLDERABLE COMPONENT AND FIELD DEVICE WITH COMPONENT
PROCÉDÉ DE FABRICATION D'UN COMPOSANT BRASABLE ET APPAREIL DE TERRAIN POURVU DE COMPOSANT

(30) Priorität: 14.04.2021 DE 102021109405
(43) Veröffentlichungstag der Anmeldung: 19.10.2022
(73) Patentinhaber: Endress+Hauser SE+Co. KG, 79689 Maulburg (DE)
(72) Erfinder: Birgel, Dietmar, 79650 Schopfheim (DE); Czaja, Silke, 79650 Schopfheim (DE)
(74) Vertreter: Hahn, Christian

(56) Entgegenhaltungen:
- DE-A1- 102017 126 724

## Beschreibung

Die Erfindung betrifft ein Verfahren zum Herstellen eines lötbaren Bauelements mit einem vorgebbaren Übergangswiderstandswert zwischen zwei Kontaktelementen. Die Kontaktelemente dienen zum Auflöten auf eine Leiterplatte. Ein mit dem erfindungsgemäßen Verfahren hergestelltes Bauelement wird bspw. in einem Feldgerät der Automatisierungstechnik eingesetzt, wobei das Bauelement auf eine Leiterplatte einer Elektronikeinheit des Feldgeräts der Automatisierungstechnik aufgelötet ist.

In der Automatisierungstechnik, insb. in der Prozessautomatisierungstechnik, werden vielfach Feldgeräte zur Bestimmung und/oder Überwachung von Prozessgrößen eingesetzt. Als Feldgeräte werden dabei im Prinzip alle Geräte bezeichnet, die prozessnah eingesetzt werden und prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Feldgeräte weisen oftmals eine, insbesondere zumindest zeitweise und/oder zumindest abschnittsweise mit einem Prozessmedium in Kontakt stehende Sensoreinheit auf, welche der Erzeugung eines von der Prozessgröße abhängigen Signals dient. Ferner weisen diese oftmals eine in einem Gehäuse angeordnete Elektronikeinheit auf, wobei die Elektronikeinheit der Verarbeitung und/oder Weiterleitung von den von der Sensoreinheit erzeugten Signalen, insbesondere elektrischen und/oder elektronischen Signalen, dient. Typischerweise umfasst die Elektronikeinheit zumindest eine Leiterplatte mit darauf angeordneten Bauelementen.

Die Elektronikeinheit weist oftmals eine Vielzahl von lötbaren Bauelementen auf, insbesondere SMD-Bauelemente, die mit entsprechenden Kontaktelementen zum Auflöten auf dafür vorgesehene Kontaktflächen auf eine Oberfläche einer Leiterplatte vorgesehen sind. SMD-lötbare Bauelemente (kurz für 'Surface Mounted Devices' d.h. oberflächen-montierbare Bauelemente) werden mit ihren Kontaktelementen direkt an für sie vorgesehene Anschlüsse aufgelötet. Hierzu werden die SMD-Bauelemente mit Bestückungsautomaten maschinell auf die mit Lotpaste versehene Kontaktflächen auf der Leiterplatte platziert und gemeinsam mit einem sogenannten Reflow-Lötprozess in einem Reflow-Lötofen aufgelötet. Damit kann gleichzeitig eine Vielzahl von SMD-lötbaren Bauelemente auf der Leiterplatte aufgelötet werden.

Derartige Bauelemente nach dem Stand der Technik weisen oftmals selbst eine Vielzahl von Lotverbindungen auf, bspw. zwischen den Kontaktelementen und/oder zwischen weiteren Komponenten des Bauelements. Für den Fall, dass eine derartige Lotverbindung vorliegt, ist es fertigungstechnisch bedingt oftmals sehr anspruchsvoll, einen vorgegebenen Übergangswiderstand zwischen den Kontaktelementen des SMD-lötbaren Bauelements zuverlässig einzustellen und/oder während der Herstellung zu überprüfen. Problematisch ist dabei auch, dass jeder Lotprozess, dem das Bauelement ausgesetzt wird, eine thermische Beanspruchung darstellt.

In der zum Zeitpunkt der Anmeldung dieser Patentanmeldung noch unveröffentlichten Patentanmeldung 10 2019 128 900.9 ist ein Verfahren zur Herstellung eines lötbaren Bauelements und ein Bauelement angegeben, das einen vorgegebenen Übergangswiderstandswert zwischen den Kontaktelementen aufweist. Das Bauelement weist eine formschlüssige Verbindung zwischen auf Anschlussflächen aufgebrachten Nanodrähten auf.

Derartige Nanodrähte und ein Bauelement aufweisend derartige Nanodrähte sind bspw. auch in der DE 10 2017 126724 A1 offenbart.

Der Erfindung liegt die Aufgabe zugrunde, ein verbessertes Verfahren zum Herstellen eines lötbaren Bauelements anzugeben, bei dem der vorgegebene Übergangswiderstandswert möglichst einfach einstellbar ist.

Die Aufgabe wird durch ein Verfahren zum Herstellen eines lötbaren Bauelements mit einem vorgebbaren Übergangswiderstandswerts zwischen zwei Kontaktelementen gelöst.

Bezüglich des Verfahrens wird die Aufgabe gelöst durch ein Verfahren zum Herstellen eines lötbaren Bauelements mit einem vorgebbaren Übergangswiderstandswert, wobei das lötbare Bauelement aufweist: ein erstes Kontaktelement und ein zweites Kontaktelement, jeweils zum Auflöten auf eine Leiterplatte,
eine mit dem ersten Kontaktelement elektrisch verbundene erste Anschlussfläche und eine mit dem zweiten Kontaktelement elektrisch verbundene zweite Anschlussfläche, wobei die Anschlussflächen bei dem Herstellen des lötbaren Bauelements miteinander elektrisch zu kontaktieren sind, und wobei das Verfahren die Schritte umfasst:
- Bereitstellen einer Vielzahl von Nanodrähten auf der ersten Anschlussfläche und auf der zweiten Anschlussfläche;
- Ausrichten der ersten Anschlussfläche und der zweiten Anschlussfläche derart, dass die erste Anschlussfläche und die zweite Anschlussfläche einander zugewandt sind;
- Zusammenführen der ersten Anschlussfläche mit der zweiten Anschlussfläche, wobei die Vielzahl der Nanodrähte der ersten Anschlussfläche mit der Vielzahl der Nanodrähte der zweiten Anschlussfläche in Kontakt gebracht wird und eine nicht-lösbare elektrisch leitende Verbindung zwischen der ersten Anschlussfläche und der zweiten Anschlussfläche hergestellt wird, mit einem Ist-Übergangswiderstandswert zwischen dem ersten Kontaktelement und dem zweiten Kontaktelement, wobei der Ist-Übergangswiderstandwert kleiner als ein vorgebbarer Soll-Übergangswiderstandswerts ist;
- Mikrostrukturieren der nicht-lösbaren elektrisch leitenden Verbindung, wobei bei dem Mikrostrukturieren durch einen Materialabtrag der Ist-Übergangswiderstandwert vergrößert wird, wobei der Ist-Übergangswiderstandswert solange durch das Mikrostrukturieren vergrößert wird, bis der Ist-Übergangswiderstandswert im Wesentlichen einem Soll-Übergangswiderstandswert entspricht.

Die Vorteile der Erfindung sind die folgenden:
Der Ist-Übergangswiderstandwert wird zunächst grob eingestellt, auf einen Wert kleiner als der vorgebbare Soll-Übergangswiderstandswerts, bei Herstellung der lotfreien Verbindung mit den Nanodrähten. Dies mittels zumindest einem der folgenden:
- der Dimension der ersten Anschlussfläche und der zweiten Anschlussfläche
- einer Querschnittsfläche der Nanodrähte und/oder einer Länge der Nanodrähte
- einer Auswahl eines Materials für die Nanodrähte.

Bevorzugterweise weisen die Nanodrähte eine Länge im Bereich von 100 nm (Nanometer) bis 100 µm (Mikrometer) auf. Weiterhin weisen die Nanodrähte bevorzugt einen Durchmesser im Bereich von 10 nm bis 100 µm, insbesondere im Bereich von 30 nm bis 2 µm auf. Dabei bezieht sich der Begriff "Durchmesser" auf eine kreisförmige Grundfläche, wobei bei einer davon abweichenden Grundfläche eine vergleichbare Definition eines Durchmessers heranzuziehen ist. Es ist besonders bevorzugt, dass alle verwendeten Nanodrähte die gleiche Länge und den gleichen Durchmesser und das gleiche Material aufweisen.

Durch die Verwendung von Nanodrähten auf den Anschlussflächen kann eine elektrisch gut leitende und mechanisch stabile formschlüssige erste Verbindung geschaffen werden, ohne dass gelötet werden muss. Daher ist das lötbare Bauelement bevorzugt frei von Lotverbindungen. Aufgrund der Größe der Nanodrähte ist die Oberfläche der Verbindung vergrößert.

Bei dem Bereitstellen der Vielzahl der Nanodrähte werden diese beispielsweise derart auf die erste Anschlussfläche und die zweite Anschlussfläche aufgebracht, dass
- die Nanodrähte einseitig an der ersten Anschlussfläche und zweiten Anschlussfläche angebracht sind
- sich in einer im Wesentlichen senkrechten Richtung zu der jeweiligen ersten oder zweiten Anschlussfläche erstrecken,
- die Nanodrähte die erste Anschlussfläche und zweite Anschlussfläche im Wesentlichen flächig bedecken.

Bei der anschließende Mikrostrukturierung wird dann der Übergangswiderstandswert zwischen den Kontaktelementen durch einen Materialabtrag in der Verbindung mit den Nanodrähten erhöht. "Mikrostrukturierung" bedeutet im Rahmen der Erfindung, dass Material der miteinander verbundenen Nanodrähte im Mikrometerbereich abgetragen wird (d.h. es muss nicht unbedingt eine definierte Struktur im Mikrometerbereich vorliegen).

Der Vorteil ist also darin zu sehen, dass nachträglich anhand der Mikrostrukturierung ein gewünschter Wert für den Übergangswiderstandswert sehr genau und einfach eingestellt werden kann.

In einer Weiterbildung der Erfindung wird der Ist-Übergangswiderstandwert während des Mikrostrukturierens ermittelt.

Die Ermittlung umfasst insbesondere eine messtechnische - direkte oder indirekte - Erfassung des Ist-Übergangswiderstandswerts. "Während des Mikrostrukturierens" bedeutet bspw., dass die Ermittlung zumindest der Überprüfung des Ergebnisses der Mikrostrukturierung dient, unmittelbar anschließend an einen ersten Mikrostrukturierungs-Schritt. Für den Fall, dass der Ist-Übergangswiderstandswert noch nicht im Wesentlichen (d.h. innerhalb einer tolerierbaren Abweichung) dem Soll-Übergangswiderstandswert entspricht, wird zumindest ein zweiter Mikrostrukturierungs-Schritt vorgenommen. Besonders bevorzugt wird der Ist-Übergangswiderstandswert im Wesentlichen kontinuierlich während der Mikrostrukturierung erfasst, bspw. um genau zu kontrollieren, dass nicht zu viel Material abgetragen wird.

In einer Ausgestaltung der letztgenannten Weiterbildung wird der Ist-Übergangswiderstandwert während des Mikrostrukturierens mittels folgender Schritte ermittelt:
- Speisen der nicht-lösbaren elektrisch leitende Verbindung zwischen dem ersten Kontaktelement und dem zweiten Kontaktelement mit einem konstanten elektrischen Strom;
- Messen eines Spannungsabfalls zwischen dem ersten Kontaktelement und dem zweiten Kontaktelements bei der Speisung mit dem konstanten elektrischen Strom;
- Ermitteln des Ist-Übergangswiderstandswerts anhand des Spannungsabfalls.

Die Speisung mit einem konstanten Strom ist bevorzugt, wenn sichergestellt werden sollte, dass der maximale Strom, mit dem die Verbindung belastet wird, während der Ermittlung des

Übergangswiderstandswerts begrenzt ist. Dies ist bspw. der Fall, wenn es sich bei dem lötbaren Bauelement (siehe untenstehende Ausgestaltung) um eine Sicherung handelt. In diesem Fall sollte der Strom kleiner als der Auslösestrom der Sicherung sein.

In einer Ausgestaltung der Erfindung erfolgt das Mikrostrukturieren mittels Lasertrimmen mit einem Laser.

Lasertrimmen ist eine aus der Dünnschicht- bzw. Dickschichttechnik bekannte Methode zur Mikrostrukturierung von Widerstandsstrukturen. Diese wird nun bevorzugt eingesetzt, um die Verbindung mit den Nanodrähten durch einen Materialabtrag nachträglich zu strukturieren.

Neben dem Lasertrimmen sind im Rahmen der Erfindung selbstverständlich auch andere aus dem Stand der Technik bekannte Methoden zur Mikrostrukturierung möglich, die einen chemischen und/oder mechanischer Materialabtrag umfassen, bspw. ein Wegätzen, das Einbringen von Mikrobohrungen, etc...

In einer Weiterbildung der Erfindung umfasst das Verfahren die Schritte:
- Ermitteln einer Temperaturverteilung in der elektrisch leitenden Verbindung während des Mikrostrukturierens;
- Lokalisieren von zumindest einem Bereich mit einem lokalen Temperatur-Maximum;
- Mikrostrukturieren derart, dass ein Materialabtrag in dem Bereich mit einem lokalen Temperatur-Maximum erfolgt.

In einer Ausgestaltung der letztgenannten Weiterbildung wird die Temperaturverteilung berührungslos ermittelt, insb. mittels eines Erfassens einer Infrarotstrahlung.

Die Temperaturverteilung lässt sich mittels der Infrarotstrahlung bspw. über eine Wärmebildkamera, ein Infrarotthermometer o.ä. ermitteln.

In einer Ausgestaltung der Erfindung umfasst das Verfahren die Schritte:
- Bereitstellen eines ersten, insb. einstückigen, metallischen Leiterelements, wobei das erste Kontaktelement gebildet ist durch einen ersten Endabschnitt des ersten Leiterelements und die erste Anschlussfläche an einem zweiten, dem ersten Endabschnitt gegenüberliegenden Endabschnitt des ersten Leiterelements angeordnet ist,
- Bereitstellen eines zweiten, insb. einstückigen, metallischen Leiterelements, wobei das zweite Kontaktelement gebildet ist durch einen ersten Endabschnitt des zweiten Leiterelements und die zweite Anschlussfläche an einem zweiten, dem ersten Endabschnitt gegenüberliegenden, Endabschnitt des zweiten Leiterelements angeordnet ist,
- Anordnen der miteinander über die elektrisch leitende Verbindung verbundenen Leiterelemente in einem elektrisch isolierenden Trägerkörper.

Bevorzugt sind beide Leiterelemente einstückig und liegen bspw. als im Form eines geformten Blechs vor. Daher treten nur minimale thermische Belastungen bei der Herstellung des Bauelements auf: Es werden als die elektrisch leitenden und den Übergangswiderstandswert bestimmenden Teile des Bauelements lediglich zwei einstückige, nur mittels der Verbindung mit den Nanodrähten miteinander verbundene Leiterelemente verwendet.

Der Trägerkörper umgibt die miteinander über die elektrisch leitende Verbindung verbundenen Leiterelemente im Wesentlichen vollständig, bis auf den das erste Kontaktelement bildenden ersten Endabschnitt des ersten Leiterelements und den das zweite Kontaktelement bildenden ersten Endabschnitt des zweiten Leiterelements.

Der Trägerkörper dient der elektrischen Isolierung und sorgt für einen zusätzlichen strukturellen Halt, bspw. indem er die Leiterelemente in ihrer Position zueinander fixiert. Die Leiterelemente sind hierzu in dem Trägerkörper bspw. vergossen oder anderweitig befestigt. Der Trägerkörper ist bevorzugt wärmeleitend und umfasst bspw. Glas und/oder Keramik, Plastik, etc..

In einer Ausgestaltung der Erfindung erfolgt das Mikrostrukturieren nach dem Anordnen der miteinander über die elektrisch leitende Verbindung verbundenen Leiterelemente in dem elektrisch isolierenden Trägerkörper, wobei der Trägerkörper zumindest eine Öffnung oder zumindest ein für den Laser optisch transparentes Fenster aufweist, so dass zumindest das Mikrostrukturieren durch die Öffnung oder durch das für den Laser optisch transparente Fenster erfolgt.

Insbesondere erfolgt das Mikrostrukturieren und das gleichzeitige (d.h. während des Mikrostrukturierens erfolgende) berührungslose Erfassen der Temperaturverteilung durch die Öffnung oder durch das für den Laser optisch transparente Fenster.

Bevorzugt werden also die beiden über die Verbindung mit der Nanodrähte verbundenen Leiterelemente vor der Mikrostrukturierung in dem Trägerkörper verkapselt. Erst anschließend, bspw. als letzten Bearbeitungsschritt in der Fertigung, findet die Mikrostrukturierung durch die Öffnung oder durch das für den Laser optisch transparente Fenster statt. Ggf. ist das Fenster auch für die Infrarotstrahlung optisch transparent. Dies ist vorteilhaft, da mit dem erfindungsgemäßen Verfahren - ausgehend von den im Wesentlichen gleichen anfänglichen Bearbeitungsschrittenunterschiedliche Bauelemente mit jeweils voneinander verschiedenen Übergangswiderstandswerten erhalten werden, wobei der genaue Ist-Übergangswiderstandswert erst durch die abschließende Mikrostrukturierung eingestellt wird.

Mittels des erfindungsgemäßen Verfahrens wird ein lötbares Bauelement,
hergestellt das Bauelement umfassend:
das erste elektrisch leitende Kontaktelement und das zweite elektrisch leitende Kontaktelement, jeweils zum Auflöten auf eine Leiterplatte,
die mit dem ersten Kontaktelement elektrisch verbundene erste Anschlussfläche und die mit dem zweiten Kontaktelement elektrisch verbundene zweite Anschlussfläche,
wobei die Anschlussflächen über eine lotfreie, elektrisch leitende Verbindung mit Nanodrähten miteinander elektrisch kontaktiert sind,
und wobei das lötbare Bauelement einen vorgegebenen Soll-Übergangswiderstandswert zwischen dem ersten Kontaktelement und dem zweiten Kontaktelement aufweist.

Das Bauelements umfasst bspw.
- ein erstes, insb. einstückiges, metallisches Leiterelement, wobei das erste Kontaktelement gebildet ist durch einen ersten Endabschnitt des ersten Leiterelements und die erste Anschlussfläche an einem dem ersten Endabschnitt gegenüberliegenden zweiten Endabschnitt des ersten Leiterelements angeordnet ist;
- ein zweites, insb. einstückiges, metallisches Leiterelement,
wobei das zweite Kontaktelement gebildet ist durch einen ersten Endabschnitt des zweiten Leiterelements und die zweite Anschlussfläche an einem dem ersten Endabschnitt gegenüberliegenden zweiten Endabschnitt des zweiten Leiterelements angeordnet ist, so dass die Leiterelemente über die elektrisch leitende Verbindung miteinander verbunden sind.

In einer Ausgestaltung des Verfahrens wird als das lötbare Bauelement ein SMD-Bauelement hergestellt, wobei die Kontaktelemente zum Auflöten auf vorgesehene SMD-Anschlussflächen vorgesehen sind.

In einer Ausgestaltung des Verfahrens werden die in dem Trägerkörper miteinander über die elektrisch leitende Verbindung verbundenen Leiterelemente derart angeordnet und verkapselt, dass der Trägerkörper die Leiterelemente im Wesentlichen vollständig umgibt, bis auf den das erste Kontaktelement bildenden ersten Endabschnitt des ersten Leiterelements und den das zweite Kontaktelement bildenden ersten Endabschnitt des zweiten Leiterelements.

In einer Ausgestaltung des Verfahrens wird ein bleifreies Bauelement hergestellt,
wobei die Nanodrähte ein Metall, insb. Kupfer, Gold, Nickel, Silber, Zink, Zinn, Indium und/oder Platin, aufweisen und wobei insbesondere die Leiterelemente Kupfer aufweisen.

In einer Ausgestaltung des Verfahrens wird als das Bauelement eine Überstromschutzeinrichtung, insb. eine Schmelzsicherung, mit einem Auslösestrom hergestellt wird, wobei als der Auslösestrom der Überstromschutzeinrichtung ein Strom zwischen 0,02 und 1 A eingestellt wird.

Der Auslösestrom ist im Wesentlichen durch den vorgebbaren Übergangswiderstandwert mitbestimmt, d.h. insbesondere ist der Soll-Übergangswiderstandswert derart eingestellt, dass der Auslösestrom der Überstromschutzeinrichtung zwischen 0,02 und 1 A ist.

In dem Fall sollte der vorstehend erwähnte gespeiste, konstante Strom in der vorstehend erwähnten Ausgestaltung des erfindungsgemäßen Verfahrens leicht unterhalb des Auslösestroms liegen, z.B. höchstens 20% kleiner, insb. höchstens 10% kleiner als der Auslösestrom sein.

Typischerweise weist das mit dem erfindungsgemäßen Verfahren hergestellte Bauelement eine Abmessung von maximal 20 mm auf, wobei insb. ein Abstand zwischen dem ersten Kontaktelement und dem zweiten Kontaktelement kleiner als 15 mm ist.

Das Bauelement ist beispielsweise in einem Feldgerät der Automatisierungstechnik mit einer Elektronikeinheit mit einer Leiterplatte verwenbar, wobei auf jeweils dafür vorgesehenen Kontaktflächen einer Leiterplatte die Kontaktelemente des erfindungsgemäßen Bauelements aufgelötet sind.

Die Erfindung wird anhand der nachfolgenden, nicht maßstabsgetreuen Figuren näher erläutert, wobei gleiche Bezugszeichen gleiche Merkmale bezeichnen. Wenn es die Übersichtlichkeit erfordert oder es anderweitig sinnvoll erscheint, wird auf bereits erwähnte Bezugszeichen in nachfolgenden Figuren verzichtet.

Es zeigen:
Fig 1: Eine Ausgestaltung der erfindungsgemäßen Vorrichtung und des erfindungsgemäßen Verfahrens;
Fig. 2a: Eine Flussdiagramm einer Ausgestaltung des erfindungsgemäßen Verfahrens;
Fig. 2b: Eine Temperaturverteilung in einer Querschnittsfläche, die in einer Ausgestaltung des erfindungsgemäßen Verfahrens erfasst wird; und
Fig. 3: Eine Ausgestaltung eines Feldgerät der Automatisierungstechnik mit einer Elektronikeinheit, die ein mittels einer Ausgestaltung des erfindungsgemäßen Verfahrens hergestelltes, lötbares Bauelements aufweist.

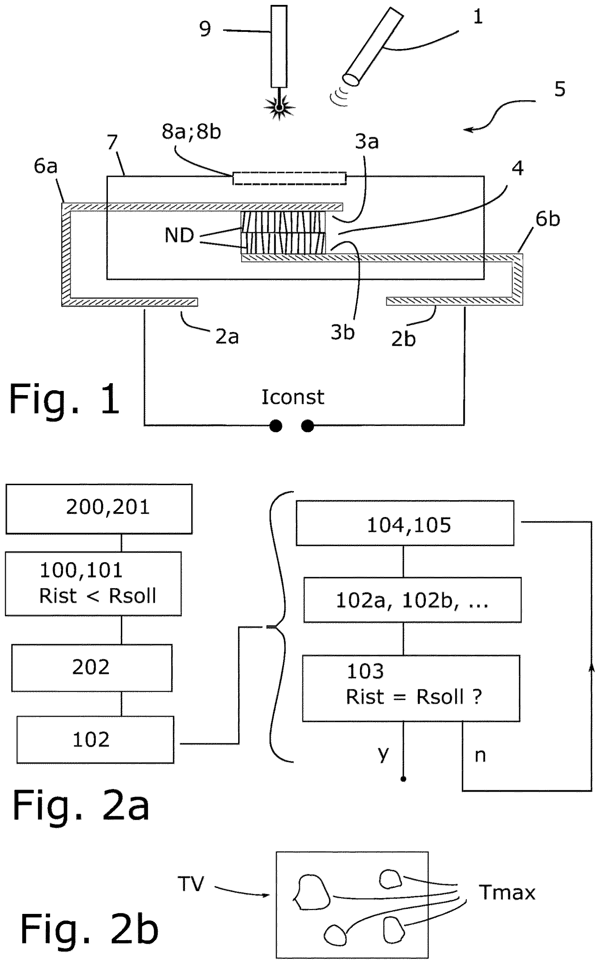

Fig. 1 zeigt einen typischen Aufbau, an dem das erfindungsgemäße Verfahren zur Herstellung des lötbaren Bauelements 5 erläutert wird.

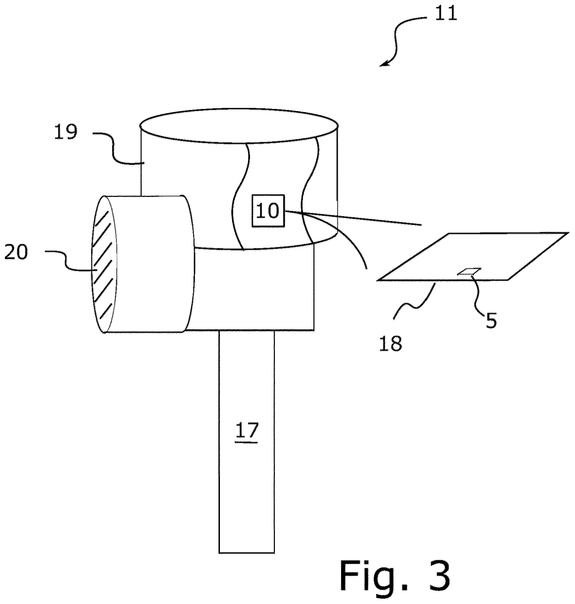

In der in Fig. 1 gezeigten Ausgestaltung ist eine bevorzugte Anordnung gezeigt, bei der ein erstes und ein zweites Leiterelement 6a,6b bereitgestellt werden. Bevorzugt sind die Leiterelemente 6a,6b aus Kupfer und einstückig. Die Leiterelemente weisen zwei Kontaktelemente 2a,2b auf. Diese dienen der elektrischen Kontaktierung mit Anschlussflächen einer Leiterplatte 18 (vgl. Fig. 3). Das erste Kontaktelement 2a ist gebildet durch einen ersten Endabschnitt des ersten Leiterelements 6a und das zweite Kontaktelement 2b ist gebildet durch einen ersten Endabschnitt des zweiten Leiterelements 6b. Hierfür sind das erstes, zweite Leiterelement 6a,6b bspw. stabförmig und weisen einen abgewinkelten ersten Endabschnitt auf.

An einem dem ersten Endabschnitt im Wesentlichen gegenüberliegenden, zweiten Endabschnitt des jeweiligen ersten, zweiten Leiterelements 6a,6b sind die erste Anschlussfläche 3a bzw. zweite Anschlussfläche 3b angeordnet, welche durch eine elektrische Verbindung 4 mit Nanodrähten ND in dem erfindungsgemäßen Verfahren miteinander zu kontaktieren sind.

Hierzu werden in einem ersten Verfahrensschritt jeweils auf die erste Anschlussfläche 3a und die zweite Anschlussfläche 3b eine Vielzahl von Nanodrähten ND bereitgestellt, bspw. mittels eines lonenspurätzverfahrens oder eines weiteren aus dem Stand der Technik bekannten Verfahrens zum Bereitstellen von Nanodrähten ND. Anschließend werden die beiden Anschlussflächen 3b einander zugewandt ausgerichtet und zusammengeführt, wodurch die auf der jeweiligen Anschlussfläche 3a,3b aufgebrachten Nanodrähten ND eine formschlüssige Verbindung bilden. Mittels der formschlüssigen Verbindung zwischen den Nanodrähten ND wird eine elektrisch leitend erste Verbindung 4 zwischen der ersten Anschlussfläche 3a und der zweiten Anschlussfläche 3b hergestellt.

Vor einem Mikrostrukturieren 102,102a,102b weist das Bauelement 5 zwischen seinen Kontaktelementen 2a,2b eine Ist-Übergangswiderstandswert Rᵢₛₜ kleiner als den vorgebbaren Soll-Übergangswiderstandswert Rₛₒₗₗ auf. Dieser anfängliche, vor dem Mikrostrukturieren 102,102a,102b vorliegende Ist-Übergangswiderstandswert Rᵢₛₜ ist durch zumindest eines der folgenden bestimmt:
- Ausgestaltung (Material und/oder Form) der Leiterelement 6a,6b und Dimension der ersten Anschlussfläche 3a und der zweiten Anschlussfläche 3b
- Querschnittsfläche der Nanodrähte ND und/oder einer Länge der Nanodrähte ND
- Material der Nanodrähte ND.

Die miteinander elektrisch verbundenen Leiterelemente 6a,6b werden anschließend in einen elektrisch isolierenden Trägerkörper 7 verkapselt. Bevorzugt weist der Trägerkörper 7 zumindest eine Öffnung 8a oder zumindest ein Fenster 8b auf, durch die die Verbindung 4 mit den Nanodrähten ND mikrostrukturierbar ist.

Die Öffnung 8a oder das Fenster 8b sind derart in Bezug zu der Verbindung 4 angeordnet, dass ein möglichst direkter Einblick in die Verbindung 4 möglich ist; dies hängt von der speziellen Form des Trägerkörpers 7 ab. Der Trägerkörper 7 kann z.B. quaderförmig oder zylinderförmig geformt sein, bei einem quaderförmigen Trägerkörper 7 ist die Öffnung 8a oder das Fenster 8b (anders als in Fig. 1 dargestellt) bspw. bevorzugt parallel zu der Papierebene angeordnet.

Anschließend erfolgt ein Mikrostrukturieren 102,102a, 102b; dies bevorzugt mittels eines Lasers 9 (Lasertrimmen) durch ein für den Laser 9 optisch transparentes Fenster 8b. Ferner wird während des Mikrostrukturierens an die beiden Kontaktelemente 2a,2b eine elektrische Spannung angelegt. Dies bevorzugt derart, dass die Kontaktelemente 2a,2b mit einem konstanten Strom I_{const} gespeist werden. Dadurch kann über einen gemessenen Spannungsabfall zwischen den Kontaktelementen 2a,2b ermittelt werden, wie groß der vorliegende Ist-Übergangswiderstandswert Rᵢₛₜ ist. Dies bevorzugt während des Mikrostrukturierens 102,102a, 102b, d.h. zwischen zwei Mikrostrukturierungsschritten 102a,102b.

Bevorzugt wird auch mittels einer Wärmebildkamera 1 oder einem Infrarotthermometer 1 über das Erfassen einer Infrarotstrahlung eine Temperaturverteilung TV in einer Querschnittsfläche der Verbindung 4 berührungslos ermittelt.

Fig. 2b zeigt eine derartige Temperaturverteilung TV in einer Querschnittsfläche der Verbindung 4, welche berührungslos durch die Öffnung 8a oder das Fenster 8b ermittelt wird. Dies bevorzugt während des Mikrostrukturierens 102,102a, 102b, d.h. zwischen zwei Mikrostrukturierungsschritten 102a,102b.

Die Verbindung 4 mit den Nanodrähten ND bildet ein Netzwerk aus zueinander im Wesentlichen parallel geschalteten Strompfaden. Je nachdem, wie groß der Widerstand R_{pfad} eines einzelnen Pfads ist, ändert sich daran verrichtete Leistung P_{pfad}. Die lokale Erwärmung aufgrund der verrichteten Leistung ist dabei wegen P_{pfad} = U^2/R_{pfad} antiproportional zu dem Widerstand des jeweiligen Pfads. Bereiche mit lokalen Temperatur-Maxima Tₘₐₓ entsprechen daher Pfaden mit kleinem Widerstand R_{pfad}. Bevorzugt erfolgt der der Materialabtrag im Rahmen der Mikrostrukturierung hauptsächlich in dem Bereich mit dem lokalen Temperatur-Maximum Tₘₐₓ. Dies ist besonders effektiv, um den Ist-Übergangswiderstandswerts Rᵢₛₜ zu erhöhen, um allmählich den Soll-Übergangswiderstandswert Rₛₒₗₗ zu erreichen.

In Fig. 2a sind die Schritte des Verfahrens in der bevorzugten Ausgestaltung noch einmal als Flussdiagramm dargestellt. Die Schritte umfassen in der folgenden Reihenfolge:
- Bereitstellen 200 des ersten Leiterelements 6a und Bereitstellen 201 des zweiten Leiterelements 6b.
- Bereitstellen 100 der Nanodrähte (ND) auf den Anschlussflächen 3a, 3bM Ausrichten der ersten Anschlussflächen 3a, 3b derart, dass die Anschlussflächen 3a, 3b, einander zugewandt sind; und Zusammenführen 101 der ersten Anschlussflächen 3a, 3b, wodurch die elektrische leitende Verbindung 4 zwischen den Anschlussflächen 3a, 3b hergestellt wird. Es liegt ein Ist-Übergangswiderstandswert Rᵢₛₜ kleiner als der Soll-Übergangswiderstandswert Rₛₒₗₗ vor.
- Anordnen 202 der miteinander über die elektrisch leitende Verbindung 4 verbundenen Leiterelemente 6a,6b in dem elektrisch isolierenden Trägerkörper 7.
- Vierter Schritt: Mikrostrukturieren 102 der Nanodrähte ND der Verbindung 4.

Während des vierten Schritt des Mikrostrukturierens 102 umfasst das erfindungsgemäße Verfahren bevorzugt in der folgenden Reihenfolge durchgeführte Schritte:
- Ermitteln 104 der Temperaturverteilung TV und Lokalisieren 105 des Temperatur-Maximums Tₘₐₓ in der elektrisch leitenden Verbindung 4;
- Vornehmen eines ersten Mikrostrukturierungs-Schritts 102a, dort, wo ein Temperatur-Maximum Tₘₐₓ in der Verbindung 4 vorliegt;
- Ermitteln 103 des Ist-Übergangswiderstandswert Rᵢₛₜ bei einer Speisung mit einem konstanten Strom I_{const},
- Falls der Ist-Übergangswiderstandswert Rᵢₛₜ nicht im Wesentlichen (d.h. bis auf eine tolerierbare Abweichung) dem Soll-Übergangswiderstandswert Rₛₒₗₗ entspricht: Wiederholen der vorherigen Schritte 104, 105, 102, 103 (wobei ein zweiter Mikrostrukturierungs-Schritt 102b vorgenommen wird).

Auch wenn vorstehend die Leiterelemente 6a,6b als einstückig beschrieben wurden, ist dies nicht wesentlich für die Erfindung, sondern nur besonders vorteilhaft. Dies aufgrund der besonders einfachen Herstellung (wenige Fertigungsschritte) des Bauelements 5. Durch die Vermeidung von Lötprozessen liegt bei der Herstellung ferner kaum bzw. im Wesentlichen keine thermische Beanspruchung vor.

Das erfindungsgemäße Verfahren eignet sich insbesondere, um eine SMD-lötbare Überstromschutzeinrichtung, insb. eine Schmelzsicherung, als das Bauelement 5 herzustellen. In diesem Fall ist der vorgebbare Soll-Übergangswiderstandswert Rₛₒₗₗ bspw. derart gewählt, dass der Auslösestrom der Überstromschutzeinrichtung zwischen 0,02 und 1 A liegt.

Das lötbare Bauelement 5 mit dem vorgebbaren Übergangswiderstandswert Rₛₒₗₗ zwischen seinen Kontaktelementen 2a,2b ist anschließend mit den Kontaktelementen 2a,2b auf dafür vorgesehene Kontaktflächen einer Leiterplatte 18 einer Elektronikeinheit 10 auflötbar, bevorzugt als SMD Bauelement 5 in einem SMD-Massenlötverfahren (bspw. einem Reflow-Löten). Das SMD-lötbare Bauelement 5 wird bevorzugt in einer Elektronikeinheit 10 eines Feldgeräts 11 der Automatisierungtechnik eingesetzt.

Ein derartiges Feldgerät 11 der Automatisierungstechnik ist in Fig. 3 näher dargestellt. Das Feldgerät 11 weist eine, insbesondere zumindest zeitweise und/oder zumindest abschnittsweise mit einem Prozessmedium in Kontakt stehende Sensoreinheit 17 auf, welche der Erzeugung eines die Prozessgröße repräsentierenden, bspw. elektrischen und/oder elektronischen, Messsignals, dient.

Die in einem Transmittergehäuse 19 des Feldgeräts 11 angeordnete Elektronikeinheit 10 dient der Verarbeitung und/oder Weiterleitung von der von der Sensoreinheit 17 erzeugten Messsignale. Typischerweise umfasst die Elektronikeinheit 10 zumindest eine Leiterplatte 18 mit darauf angeordneten Bauelementen. Auf der Leiterplatte 18 ist das erfindungsgemäße, SMD-lötbare Bauelement 5 aufgelötet.

In der in Fig. 4 gezeigten Ausgestaltung weist das Feldgerät 11 eine weitere, als Anzeige-/Eingabeeinheit ausgestaltete Elektronikeinheit 20 auf, mit einem darauf montierten (Touch-)Display. Das erfindungsgemäße SMD-lötbare Bauelement 5 kann selbstverständlich auch auf einer Leiterplatte der als Anzeige-/Eingabeeinheit ausgestalteten Elektronikeinheit 20 aufgelötet sein kann.

Bspw. handelt es sich bei dem mit dem erfindungsgemäßen Verfahren hergestellten SMD-lötbaren Bauelement 5 um die vorstehend genannte Überstromschutzeinrichtung (d.h. mit der vorstehend genannten Abmessung bzw. dem vorstehend genannten Auslösestrom), welche bei einem Feldgerät 11 eingesetzt wird, das für den Einsatz in explosionsgefährdeten Bereichen ausgestaltet ist.

Derartige Feldgeräte 11 müssen sehr hohen Sicherheitsanforderungen hinsichtlich des Explosionsschutzes genügen. Beim Explosionsschutz geht es insb. darum, die Bildung von Funken sicher zu vermeiden oder zumindest sicherzustellen, dass ein im Fehlerfall entstandener Funken keine Auswirkungen auf die Umgebung hat. Hierfür sind in entsprechende Normen eine Reihe von dazugehörigen Schutzklassen definiert, insbesondere in der europäischen Norm IEC 600079-11 und/oder EN60079-11.

Vergleichbare Schutzklassen sind in der amerikanischen Norm FM3610 und/oder der ANSI/UL60079-11 und/oder der kanadischen Norm CAN/CAS C22.2 No. 60079-11 definiert. Das SMD-lötbare Bauelement 5, d.h. die SMD-lötbare Überstromschutzeinrichtung, wird also bei einer für den Einsatz in explosionsgefährdeten Bereichen ausgestalteten Elektronikeinheit 10,20 verwendet. Insb. ist also die Elektronikeinheit 10,20 gemäß einer Schutzklasse der vorstehend genannten Normen ausgestaltet. Hierbei ist die Zuverlässigkeit der erfindungsgemäßen Überstromschutzeinrichtung von besonders großer Bedeutung.

## Patentansprüche

1. Verfahren zum Herstellen eines lötbaren Bauelements (5) mit einem vorgebbaren Übergangswiderstandswert (Rₛₒₗₗ), wobei das lötbare Bauelement (5) aufweist:
ein erstes Kontaktelement (2a) und ein zweites Kontaktelement (2b), jeweils zum Auflöten auf eine Leiterplatte (18),
eine mit dem ersten Kontaktelement (2a) elektrisch verbundene erste Anschlussfläche (3a) und eine mit dem zweiten Kontaktelement (2b) elektrisch verbundene zweite Anschlussfläche (3b), wobei die Anschlussflächen (2a,2b) bei dem Herstellen des lötbaren Bauelements (5) miteinander elektrisch zu kontaktieren sind,
und wobei das Verfahren die Schritte umfasst:
- Bereitstellen (100) einer Vielzahl von Nanodrähten (ND) auf der ersten Anschlussfläche (3a) und auf der zweiten Anschlussfläche (3b);
- Ausrichten (101a) der ersten Anschlussfläche (3a) und der zweiten Anschlussfläche (3b) derart, dass die erste Anschlussfläche (3a) und die zweite Anschlussfläche (3b) einander zugewandt sind;
- Zusammenführen (101b) der ersten Anschlussfläche (3a) mit der zweiten Anschlussfläche (3b), wobei die Vielzahl der Nanodrähte (ND) der ersten Anschlussfläche (3a) mit der Vielzahl der Nanodrähte (ND) der zweiten Anschlussfläche (3b) in Kontakt gebracht wird,
**dadurch gekennzeichnet, dass** eine nicht-lösbare elektrisch leitende Verbindung (4) zwischen der ersten Anschlussfläche (3a) und der zweiten Anschlussfläche (3b) hergestellt wird, mit einem Ist-Übergangswiderstandswert (Rᵢₛₜ) zwischen dem ersten Kontaktelement (2a) und dem zweiten Kontaktelement (2b), wobei der Ist-Übergangswiderstandwert (Rᵢₛₜ) kleiner als ein vorgebbarer Soll-Übergangswiderstandswerts (Rₛₒₗₗ) ist;
- Mikrostrukturieren (102, 102a, 102b) der nicht-lösbaren elektrisch leitenden Verbindung (4), wobei bei dem Mikrostrukturieren (102, 102a, 102b) durch einen Materialabtrag der Ist-Übergangswiderstandwert (Rᵢₛₜ) vergrößert wird, wobei der Ist-Übergangswiderstandswert (Rᵢₛₜ) solange durch das Mikrostrukturieren (102, 102a, 102b) vergrößert wird, bis der Ist-Übergangswiderstandswert (Rᵢₛₜ) im Wesentlichen einem Soll-Übergangswiderstandswert (Rₛₒₗₗ) entspricht.

2. Verfahren nach Anspruch 1, umfassend den Schritt:
Ermitteln (103) des Ist-Übergangswiderstandwert (Rᵢₛₜ) während des Mikrostrukturierens (102, 102a, 102b).

3. Verfahren nach Anspruch 2,
wobei der Ist-Übergangswiderstandwert (Rᵢₛₜ) während des Mikrostrukturierens (102, 102a, 102b) mittels folgender Schritte ermittelt wird:
- Speisen der nicht-lösbaren elektrisch leitende Verbindung (4) zwischen dem ersten Kontaktelement (2a) und dem zweiten Kontaktelement (2b) mit einem konstanten elektrischen Strom (I_{const});
- Messen eines Spannungsabfalls zwischen dem ersten Kontaktelement (2a) und dem zweiten Kontaktelements (2b) bei der Speisung mit dem konstanten elektrischen Strom (I_{const});
- Ermitteln des Ist-Übergangswiderstandswerts (Rᵢₛₜ) anhand des Spannungsabfalls.

4. Verfahren nach zumindest einem der vorherigen Ansprüche,
wobei das Mikrostrukturieren (102, 102a, 102b) mittels Lasertrimmen mit einem Laser (9) erfolgt.

5. Verfahren nach zumindest einem der vorherigen Ansprüche,
umfassend die Schritte:
- Ermitteln (104) einer Temperaturverteilung (TV) in der elektrisch leitenden Verbindung (4) während des Mikrostrukturierens (102, 102a, 102b);
- Lokalisieren (105) von zumindest einem Bereich mit einem lokalen Temperatur-Maximum (Tₘₐₓ);
- Mikrostrukturieren ((102, 102a, 102b) derart, dass ein Materialabtrag in dem Bereich mit einem lokalen Temperatur-Maximum, erfolgt.

6. Verfahren nach Anspruch 5,
wobei die Temperaturverteilung (TV) berührungslos ermittelt wird, insb. mittels eines Erfassens einer Infrarotstrahlung.

7. Verfahren nach zumindest einem der vorherigen Ansprüche,
umfassend die Schritte:
- Bereitstellen (200) eines ersten, insb. einstückigen, metallischen Leiterelements (6a), wobei das erste Kontaktelement (2a) gebildet ist durch einen ersten Endabschnitt des ersten Leiterelements (6a) und die erste Anschlussfläche (3a) an einem zweiten, dem ersten Endabschnitt gegenüberliegenden Endabschnitt des ersten Leiterelements (6a) angeordnet ist,
- Bereitstellen (202) eines zweiten, insb. einstückigen, metallischen Leiterelements (6b), wobei das zweite Kontaktelement (2b) gebildet ist durch einen ersten Endabschnitt des zweiten Leiterelements(6b) und die zweite Anschlussfläche (3b) an einem zweiten, dem ersten Endabschnitt gegenüberliegenden, Endabschnitt des zweiten Leiterelements (6b) angeordnet ist,
- Anordnen (202) der miteinander über die elektrisch leitende Verbindung (4) verbundenen Leiterelemente (6a, 6b) in einem elektrisch isolierenden Trägerkörper (7).

8. Verfahren nach Anspruch 7,
wobei das Mikrostrukturieren (102; 102a, 102b) nach dem Anordnen (202) der miteinander über die elektrisch leitende Verbindung (4) verbundenen Leiterelemente (6a,6b) in dem elektrisch isolierenden Trägerkörper (7) erfolgt,
und wobei der Trägerkörper (7) zumindest eine Öffnung (8a) oder zumindest ein für den Laser (9) optisch transparentes Fenster (8b) aufweist,
so dass zumindest das Mikrostrukturieren (102; 102a, 102b) durch die Öffnung (8a) oder durch das für den Laser (9) optisch transparente Fenster (8b) erfolgt.

9. Verfahren nach zumindest einem der vorherigen Ansprüche,
wobei als das lötbare Bauelement (5) ein SMD-Bauelement hergestellt wird, und wobei die Kontaktelemente (2a,2b) zum Auflöten auf vorgesehene SMD-Anschlussflächen vorgesehen sind.

10. Verfahren nach zumindest einem der vorherigen Ansprüche 7 bis 9,
wobei die in dem Trägerkörper (7) miteinander über die elektrisch leitende Verbindung (4) verbundenen Leiterelemente (6a,6b) derart angeordnet und verkapselt werden,
dass der Trägerkörper (7) die Leiterelemente (6a,6b) im Wesentlichen vollständig umgibt, bis auf den das erste Kontaktelement (2a) bildenden ersten Endabschnitt des ersten Leiterelements (6a) und den das zweite Kontaktelement (2b) bildenden ersten Endabschnitt des zweiten Leiterelements (6b).

11. Verfahren nach zumindest einem der vorherigen Ansprüche, wobei ein bleifreies Bauelement (5) hergestellt wird und wobei die Nanodrähte (ND) ein Metall, insb. Kupfer, Gold, Nickel, Silber, Zink, Zinn, Indium und/oder Platin, aufweisen,
und wobei insbesondere die Leiterelemente Kupfer aufweisen.

12. Verfahren nach zumindest einem der vorherigen Ansprüche, wobei als das Bauelement (5) eine Überstromschutzeinrichtung, insb. eine Schmelzsicherung, mit einem Auslösestrom hergestellt wird, und wobei als der Auslösestrom der Überstromschutzeinrichtung ein Strom zwischen 0,02 und 1 A eingestellt wird.

## Claims

1. Method for producing a solderable component (5) with a predeterminable contact resistance value (Rₛₒₗₗ ), the solderable component (5) having:
a first contact element (2a) and a second contact element (2b), each for soldering onto a printed circuit board (18),
a first connection surface (3a) electrically connected to the first contact element (2a) and a second connection surface (3b) electrically connected to the second contact element (2b), wherein the connection surfaces (2a, 2b) are to be electrically contacted with one another during the manufacture of the solderable component (5),
and wherein the method comprises the steps of:
- Providing (100) a plurality of nanowires (ND) on the first connection surface (3a) and on the second connection surface (3b);
- Aligning (101a) the first connecting surface (3a) and the second connecting surface (3b) in such a way that the first connecting surface (3a) and the second connecting surface (3b) face each other;
- bringing together (101b) the first connection surface (3a) with the second connection surface (3b), wherein the plurality of nanowires (ND) of the first connection surface (3a) is brought into contact with the plurality of nanowires (ND) of the second connection surface (3b),
**characterized in that** a non-detachable electrically conductive connection (4) between the
first connection surface (3a) and the second connection surface (3b) is produced, with an actual contact resistance value (Rᵢₛₜ) between the first contact element (2a) and the second contact element (2b), wherein the actual contact resistance value (Rᵢₛₜ ) is smaller than a predeterminable nominal contact resistance value (Rₛₒₗₗ );
- Microstructuring (102, 102a, 102b) of the non-detachable electrically conductive connection (4), wherein during the microstructuring (102, 102a, 102b) the actual contact resistance value (Rᵢₛₜ) is increased by a material removal, wherein the actual contact resistance value (Rᵢₛₜ) is increased by the microstructuring (102, 102a, 102b) until the actual contact resistance value (Rᵢₛₜ ) substantially corresponds to a desired contact resistance value (Rₛₒₗₗ ).

2. The method according to claim 1, comprising the step of:
Determining (103) the actual contact resistance value (Rᵢₛₜ ) during microstructuring (102, 102a, 102b).

3. Method according to claim 2,
wherein the actual contact resistance value (Rᵢₛₜ) is determined during microstructuring (102, 102a, 102b) by means of the following steps:
- Feeding the non-detachable electrically conductive connection (4) between the first contact element (2a) and the second contact element (2b) with a constant electrical current (I_{const} );
- Measurement of a voltage drop between the first contact element
(2a) and the second contact element (2b) when supplied with the constant electric current (I_{const} );
- Determine the actual contact resistance value (Rᵢₛₜ ) using the voltage drop.

4. Method according to at least one of the preceding claims,
wherein the microstructuring (102, 102a, 102b) is carried out by means of laser trimming with a laser (9).

5. Method according to at least one of the preceding claims,
comprising the steps:
- Determining (104) a temperature distribution (TV) in the electrically conductive compound (4) during microstructuring (102, 102a, 102b);
- Localization (105) of at least one area with a local temperature maximum (Tₘₐₓ );
- Microstructuring ((102, 102a, 102b) in such a way that material is removed in the area with a local temperature maximum.

6. Method according to claim 5,
whereby the temperature distribution (TV) is determined without contact, in particular by detecting infrared radiation.

7. Method according to at least one of the preceding claims,
comprising the steps:
- Provision (200) of a first, in particular one-piece, metallic conductor element (6a), wherein the first contact element (2a) is formed by a first end section of the first conductor element (6a) and the first connection surface (3a) is arranged on a second end section of the first conductor element (6a) opposite the first end section,
- Provision (202) of a second, in particular one-piece, metallic conductor element (6b), wherein the second contact element (2b) is formed by a first end section of the second conductor element (6b) and the second connection surface (3b) is arranged on a second end section of the second conductor element (6b) opposite the first end section,
- Arrangement (202) of the conductor elements (6a, 6b) connected to one another via the electrically conductive connection (4) in an electrically insulating carrier body (7).

8. Method according to claim 7,
wherein the microstructuring (102; 102a, 102b) takes place after the arrangement (202) of the conductor elements (6a, 6b) connected to one another via the electrically conductive connection (4) in the electrically insulating carrier body (7),
and wherein the carrier body (7) has at least one opening (8a) or at least one window (8b) which is optically transparent to the laser (9),
so that at least the microstructuring (102; 102a, 102b) takes place through the opening (8a) or through the window (8b) which is optically transparent to the laser (9).

9. Method according to at least one of the preceding claims,
wherein an SMD component is produced as the solderable component (5), and wherein the contact elements (2a, 2b) are provided for soldering onto provided SMD connection surfaces.

10. Method according to at least one of the preceding claims 7 to 9,
wherein the conductor elements (6a, 6b) connected to one another in the carrier body (7) via the electrically conductive connection (4) are arranged and encapsulated in this way,
in that the carrier body (7) substantially completely surrounds the conductor elements (6a, 6b), except for the first end section of the first conductor element (6a) forming the first contact element (2a) and the first end section of the second conductor element (6b) forming the second contact element (2b).

11. Method according to at least one of the preceding claims, wherein a lead-free component (5) is produced and wherein the nanowires (ND) comprise a metal, in particular copper, gold, nickel, silver, zinc, tin, indium and/or platinum,
and in particular the conductor elements comprise copper.

12. Method according to at least one of the preceding claims, wherein an overcurrent protection device, in particular a fuse, with a tripping current is produced as the component (5),
and where a current between 0.02 and 1 A is set as the tripping current of the overcurrent protection device.

## Revendications

1. Procédé de fabrication d'un composant (5) soudable ayant une valeur de résistance de contact (Rₛₒₗₗ ) pouvant être prédéterminée, le composant (5) soudable présentant :
un premier élément de contact (2a) et un deuxième élément de contact (2b), chacun destiné à être soudé sur une carte de circuit imprimé (18),
une première surface de connexion (3a) reliée électriquement au premier élément de contact (2a) et une deuxième surface de connexion (3b) reliée électriquement au deuxième élément de contact (2b), les surfaces de connexion (2a, 2b) devant être mises en contact électrique l'une avec l'autre lors de la fabrication du composant soudable (5),
et dans lequel le procédé comprend les étapes consistant à
- fournir (100) une pluralité de nanofils (ND) sur la première surface de connexion (3a) et sur la seconde surface de connexion (3b) ;
- l'alignement (101a) de la première surface de connexion (3a) et de la seconde surface de borne (3b) de sorte que la première surface de connexion (3a) et la seconde surface de borne (3b) se font face ;
- la mise en contact (101b) de la première plage de connexion (3a) avec la seconde plage de connexion (3b), dans laquelle la pluralité de nanofils (ND) de la première plage de connexion (3a) est mise en contact avec la pluralité de nanofils (ND) de la seconde plage de connexion (3b),
**caractérisé en ce qu'**une connexion électriquement conductrice non détachable (4) est établie entre la première surface de connexion (3a) et la deuxième surface de connexion (3b), avec une valeur de résistance de contact réelle (Rᵢₛₜ ) entre le premier élément de contact (2a) et le deuxième élément de contact (2b), la valeur de résistance de contact réelle (Rᵢₛₜ ) étant inférieure à une valeur de résistance de contact de consigne (Rₛₒₗₗ ) pouvant être prédéfinie ;
- la microstructuration (102, 102a, 102b) de la liaison électriquement conductrice (4) non détachable, la valeur de résistance de transition réelle (Rᵢₛₜ ) étant augmentée lors de la microstructuration (102, 102a, 102b) par un enlèvement de matière, la valeur de résistance de transition réelle (Rᵢₛₜ ) étant augmentée par la microstructuration (102, 102a, 102b) jusqu'à ce que la valeur de résistance de transition réelle (Rᵢₛₜ ) corresponde essentiellement à une valeur de résistance de transition de consigne (Rₛₒₗₗ ).

2. Procédé selon la revendication 1, comprenant l'étape consistant à :
déterminer (103) la valeur de résistance de transition réelle (Rᵢₛₜ ) pendant la microstructuration (102, 102a, 102b).

3. Procédé selon la revendication 2,
la valeur de résistance de transition réelle (Rᵢₛₜ ) étant déterminée pendant la microstructuration (102, 102a, 102b) au moyen des étapes suivantes :
- alimenter la connexion électriquement conductrice non détachable (4) entre le premier élément de contact (2a) et le deuxième élément de contact (2b) avec un courant électrique constant (I_{const} ) ;
- Mesure d'une chute de tension entre le premier élément de contact (2a) et le deuxième élément de contact (2b) lorsqu'il est alimenté par le courant électrique constant (I_{const} ) ;
- Détermination de la valeur réelle de la résistance de transition (Rᵢₛₜ ) à l'aide de la chute de tension.

4. Procédé selon au moins une des revendications précédentes,
la microstructuration (102, 102a, 102b) étant réalisée au moyen d'un ajustage laser avec un laser (9).

5. Procédé selon au moins une des revendications précédentes,
comprend les étapes :
- déterminer (104) une distribution de température (TV) dans le composé électriquement conducteur (4) pendant la microstructuration (102, 102a, 102b) ;
- localiser (105) au moins une zone présentant un maximum local de température (Tₘₐₓ ) ;
- microstructurer (102, 102a, 102b) de telle sorte qu'un enlèvement de matière soit effectué dans la zone présentant un maximum local de température.

6. Procédé selon la revendication 5,
la distribution de température (TV) étant déterminée sans contact, notamment au moyen d'une détection d'un rayonnement infrarouge.

7. Procédé selon au moins une des revendications précédentes,
comprend les étapes:
- Préparation (200) d'un premier élément conducteur métallique (6a), en particulier d'une seule pièce, le premier élément de contact (2a) étant formé par une première section d'extrémité du premier élément conducteur (6a) et la première surface de connexion (3a) étant disposée sur une deuxième section d'extrémité du premier élément conducteur (6a), opposée à la première section d'extrémité,
- la mise à disposition (202) d'un deuxième élément conducteur métallique (6b), en particulier d'une seule pièce, le deuxième élément de contact (2b) étant formé par une première partie d'extrémité du deuxième élément conducteur (6b) et la deuxième surface de raccordement (3b) étant disposée sur une deuxième partie d'extrémité, opposée à la première partie d'extrémité, du deuxième élément conducteur (6b),
- disposer (202) les éléments conducteurs (6a, 6b) reliés entre eux par la connexion électriquement conductrice (4) dans un corps de support électriquement isolant (7).

8. Procédé selon la revendication 7,
la microstructuration (102 ; 102a, 102b) étant effectuée après la mise en place (202) des éléments conducteurs (6a, 6b) reliés entre eux par la liaison électriquement conductrice (4) dans le corps de support électriquement isolant (7),
et dans lequel le corps de support (7) présente au moins une ouverture (8a) ou au moins une fenêtre (8b) optiquement transparente pour le laser (9),
de sorte qu'au moins la microstructuration (102 ; 102a, 102b) s'effectue à travers l'ouverture (8a) ou à travers la fenêtre (8b) optiquement transparente pour le laser (9).

9. Procédé selon au moins une des revendications précédentes,
dans lequel un composant SMD est fabriqué en tant que composant soudable (5), et dans lequel les éléments de contact (2a, 2b) sont prévus pour être soudés sur des surfaces de raccordement SMD prévues.

10. Procédé selon au moins l'une des revendications précédentes 7 à 9,
dans lequel les éléments conducteurs (6a, 6b) reliés entre eux dans le corps de support (7) par l'intermédiaire de la connexion électriquement conductrice (4) sont disposés et encapsulés de cette manière,
en ce que le corps de support (7) entoure sensiblement complètement les éléments conducteurs (6a, 6b), à l'exception de la première section d'extrémité du premier élément conducteur (6a) formant le premier élément de contact (2a) et de la première section d'extrémité du deuxième élément conducteur (6b) formant le deuxième élément de contact (2b).

11. Procédé selon au moins l'une des revendications précédentes, dans lequel un composant sans plomb (5) est fabriqué et dans lequel les nanofils (ND) comprennent un métal, en particulier le cuivre, l'or, le nickel, l'argent, le zinc, l'étain, l'indium et/ou le platine,
et dans lequel, en particulier, les éléments conducteurs comprennent du cuivre.

12. Procédé selon au moins l'une des revendications précédentes, dans lequel on fabrique comme composant (5) un dispositif de protection contre les surintensités, en particulier un fusible, avec un courant de déclenchement,
et dans lequel un courant compris entre 0,02 et 1 A est réglé comme courant de déclenchement du dispositif de protection contre les surintensités.
